(19)

**Europäisches Patentamt**
**European Patent Office**
**Office européen des brevets**

(11) **EP 4 611 049 A1**

(12) **EUROPEAN PATENT APPLICATION**
published in accordance with Art. 153(4) EPC

(43) Date of publication:
**03.09.2025 Bulletin 2025/36**

(21) Application number: **23882596.2**

(22) Date of filing: **24.10.2023**

(51) International Patent Classification (IPC):
$H01L\ 33/10^{(2010.01)}$      $H01L\ 33/06^{(2010.01)}$
$H01L\ 33/32^{(2010.01)}$      $H01L\ 33/42^{(2010.01)}$

(52) Cooperative Patent Classification (CPC):
**H10H 20/812; H10H 20/814; H10H 20/825;**
**H10H 20/833**

(86) International application number:
**PCT/JP2023/038231**

(87) International publication number:
**WO 2024/090391 (02.05.2024 Gazette 2024/18)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **24.10.2022 JP 2022169829**

(71) Applicants:
- **RIKEN**
  **Wako-shi, Saitama 351-0198 (JP)**
- **Shibaura Machine Co., Ltd.**
  **Tokyo 100-0011 (JP)**
- **TOKYO OHKA KOGYO CO., LTD.**
  **Kawasaki-shi, Kanagawa 211 0012 (JP)**
- **Dai Nippon Printing Co., Ltd.**
  **Tokyo 162-8001 (JP)**
- **ULVAC, Inc.**
  **Chigasaki-shi, Kanagawa 253-8543 (JP)**

(72) Inventors:
- **HIRAYAMA Hideki**
  **Wako-shi, Saitama 351-0198 (JP)**

- **KASHIMA Yukio**
  **Wako-shi, Saitama 351-0198 (JP)**
- **MATSUURA Eriko**
  **Wako-shi, Saitama 351-0198 (JP)**
- **SHINOHARA Hidetoshi**
  **Numazu-shi, Shizuoka 410-8510 (JP)**
- **IWAI Takeshi**
  **Kawasaki-shi, Kanagawa 211-0012 (JP)**
- **NAGANO Tsugumi**
  **Tokyo 162-8001 (JP)**
- **KAMIMURA Ryuichiro**
  **Chigasaki-shi, Kanagawa 253-8543 (JP)**
- **OSADA Yamato**
  **Chigasaki-shi, Kanagawa 253-8543 (JP)**
- **IWAISAKO Yasushi**
  **Fukuoka-shi, Fukuoka 812-8538 (JP)**
- **OOGAMI Hiroyuki**
  **Fukuoka-shi, Fukuoka 812-8538 (JP)**
- **MOURI Kengo**
  **Fukuoka-shi, Fukuoka 812-8538 (JP)**

(74) Representative: **Gleiss Große Schrell und Partner**
**mbB**
**Leitzstraße 45**
**70469 Stuttgart (DE)**

(54) **DEEP ULTRAVIOLET LED**

(57)    Provided is a deep ultraviolet LED having an improved light extraction efficiency (LEE). The deep ultraviolet LED with an emission wavelength λ includes, in order from an opposite side of a substrate: a p-type electrode layer made of indium tin oxide (ITO); a p-GaN contact layer; a p-AlGaN layer transparent to the wavelength λ; an electron barrier layer transparent to the wavelength λ; a multi-quantum well layer transparent to the wavelength λ; and a n-AlGaN layer transparent to the wavelength λ. The deep ultraviolet LED includes a photonic crystal periodic structure having a plurality of pillars within a range in a thickness direction from an upper portion of the p-type electrode layer to an inside of the n-AlGaN layer, in a direction of the substrate. The photonic crystal periodic structure has a photonic band gap that is open to a TM polarized component. A period $a$ of the photonic crystal periodic structure satisfies a Bragg condition ($m \times \lambda/n_{eff} = 2a$, m: order, $n_{eff}$: effective refractive index of the photonic crystal periodic structure) with respect to a light with the wavelength λ, the order $m$ satisfies $3 \le m \le 7$, and a radius R of the pillar satisfies $0.25 \le R/a \le 0.35$.

**EP 4 611 049 A1**

# Fig. 1

(a)

z

100

101

a

R

a

(b)

y

x

9

1. Sapphire Substrate
2. AlN Layer
3. n-AlGaN Layer
4. Multi-Quantum Well Layer
5. Electron Barrier Layer
6. p-AlGaN Layer

7. p-GaN Contact Layer
8. p-Type Electrode Layer (ITO)
9. Air
100. Photonic Crystal Periodic Structure
101. Pillar

**Description**

Technical Field

The present invention relates to a deep ultraviolet LED, and specifically, an AlGaN-based deep ultraviolet LED.

Background Art

A deep ultraviolet LED (UVC-LED) with an emission wavelength from 220 nm to 280 nm has been attracting attention as technology for inactivating COVID-19 virus. However, the LED has its wall-plug efficiency (WPE) as low as approximately 3% that is significantly lower than that of 20% derived from a mercury lamp. This is mainly attributable to the low light extraction efficiency (LEE) of approximately 6% as a p-GaN contact layer absorbs most of emitted light.
According to Patent Literature 1, the photonic crystal is provided in the thickness direction in a region including an interface between the p-GaN contact layer and the p-AlGaN layer to suppress the light absorption by reflecting light. Provided that an enhancement factor of the LEE with the emission wavelength of 280 nm is set to 2.76 as a maximum value, and the LEE of the structure having no photonic crystal is 6%, the LEE of the structure having the photonic crystal results in 16.6%. The ratio between TE light and TM light with the emission wavelength of 280 nm is 7:3.

Citation List

Patent Literature

Patent Literature 1: Japanese Patent No. 6156898

Summary of Invention

Technical Problem

The photonic crystal as disclosed in Patent Literature 1 exhibits a substantially 100% reflection effect with respect to TE light. On the contrary, the reflection effect with respect to TM light cannot be obtained. Furthermore, as the emission wavelength is shortened to 220 nm, the ratio of TM light is increased, thus reducing the LEE.
It is an object of the present invention to provide new technology for improving the LEE of the UVC-LED.

Solution to Problem

One example of a deep ultraviolet LED according to the present invention is a deep ultraviolet LED with an emission wavelength $\lambda$, including, in order from an opposite side of a substrate:

a p-type electrode layer made of indium tin oxide (ITO);
a p-GaN contact layer;
a p-AlGaN layer transparent to the wavelength $\lambda$;
an electron barrier layer transparent to the wavelength $\lambda$;
a multi-quantum well layer transparent to the wavelength $\lambda$; and
a n-AlGaN layer transparent to the wavelength $\lambda$;
wherein the deep ultraviolet LED includes a photonic crystal periodic structure having a plurality of pillars within a range in a thickness direction from an upper portion of the p-type electrode layer to an inside of the n-AlGaN layer, in a direction of the substrate,
wherein the photonic crystal periodic structure has a photonic band gap that is open to a TM polarized component,
wherein a period $\boldsymbol{a}$ of the photonic crystal periodic structure satisfies a Bragg condition ($m \times \lambda/n_{eff}$ = 2a, m: order, $n_{eff}$: effective refractive index of the photonic crystal periodic structure) with respect to a light with the wavelength $\lambda$,
the order $\boldsymbol{m}$ satisfies $3 \leq \boldsymbol{m} \leq 7$, and
a radius R of the pillar satisfies $0.25 \leq R/a \leq 0.35$.

In one example, an insulating layer made of $SiO_2$ fills a space region of the photonic crystal periodic structure. This specification includes the content disclosed in Japanese Patent Application No. 2022-169829 on the basis of a priority of the present invention.

Advantageous Effects of Invention

According to the present invention, a pillar-type photonic crystal periodic structure allows significant improvement in the LEE of the UVC-LED.

Brief Description of Drawings

Fig. 1 illustrates a structure of a UVC-LED with an emission wavelength $\lambda$ of 220 nm according to a first embodiment (a cross-sectional view and a plan view).

Fig. 2 represents each photonic band structure of TE light and TM light, which have been analyzed by a plane wave expansion method under the conditions of the emission wavelength of 220 nm, a refractive index $n_1 = 2.814$ of the p-GaN contact layer, an air refractive index of $n_2 = 1$, and R/a = 0.30 as a ratio of pillar radius R to a period *a.*

Fig. 3 is a graph having a horizontal axis as the R/a, and a vertical axis as a size of PBG ($\Delta$PBG).

Fig. 4A illustrates a computation model for analysis by a FDTD method in the presence of the photonic crystal periodic structure.

Fig. 4B illustrates a computation model for analysis by the FDTD method in the absence of the photonic crystal periodic structure.

Fig. 5A is a graph for each R/a for the emission wavelength of 220 nm, having a horizontal axis as the order *m,* and a vertical axis as the enhancement factor.

Fig. 5B is a graph for each R/a for the emission wavelength of 280 nm, having a horizontal axis as the order *m,* and a vertical axis as the enhancement factor.

Fig. 6A is an electric field diagram of an electric field intensity obtained in the presence of the photonic crystal periodic structure.

Fig. 6B is an electric field diagram of an electric field intensity obtained in the absence of the photonic crystal periodic structure.

Fig. 7 is a graph having a horizontal axis as a radiation angle, and a vertical axis as an output power.

Fig. 8 illustrates a structure of a UVC-LED with an emission wavelength $\lambda$ of 220 nm according to a second embodiment (a cross-sectional view and a plan view).

Fig. 9A is a graph for each R/a for the emission wavelength of 220 nm, having a horizontal axis as the order *m,* and a vertical axis as the enhancement factor according to the second embodiment.

Fig. 9B is a graph for each R/a for the emission wavelength of 280 nm, having a horizontal axis as the order *m,* and a vertical axis as the enhancement factor according to the second embodiment.

Description of Embodiments

The deep ultraviolet LED (which may be referred to as "UVC-LED" hereinafter) according to embodiments of the present invention will be described in detail with reference to the drawings.

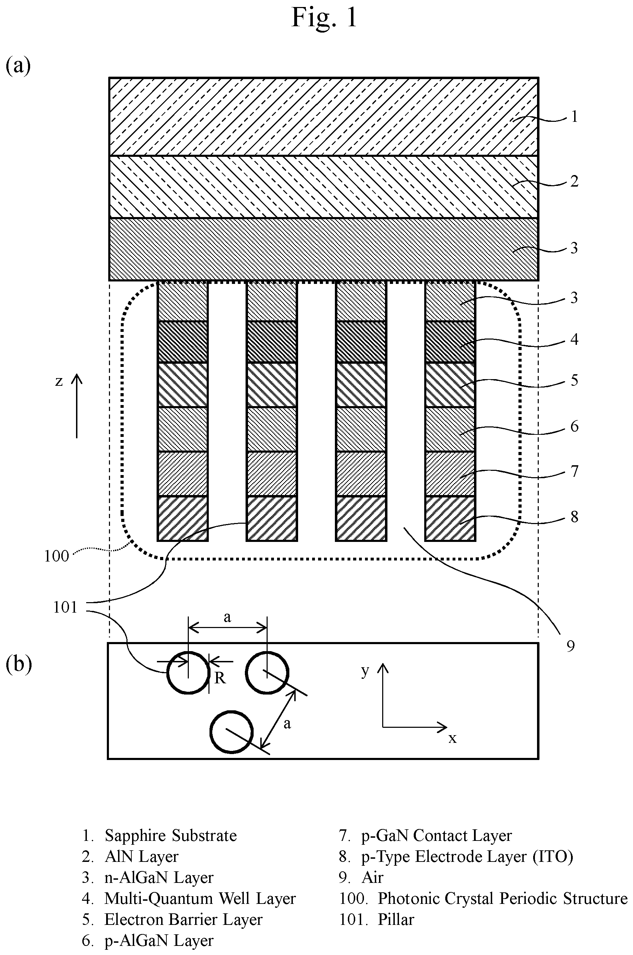

Fig. 1 illustrates a structure of the UVC-LED (a cross-sectional view and a plan view) with an emission wavelength $\lambda$ of 220 nm as the UVC-LED according to a first embodiment of the present invention. Fig. 1(a) is a cross-sectional view, and Fig. 1(b) is a plan view seen from the lower direction of the drawing of Fig. 1(a).

An xyz orthogonal coordinate system is defined as the coordinate system for the purpose of description. A stacking direction in Fig. 1(a), that is, the upper-lower direction of the drawing is defined as a z-direction. Specifically, the upward direction of the drawing is defined as a +z-direction, and the downward direction of the drawing is defined as a -z-direction. The cross section is parallel to an xy-plane.

As illustrated in the cross-sectional view of Fig. 1(a), a photonic crystal periodic structure 100 is formed of, in order from the +z-side to the -z-side, a sapphire substrate 1, an AlN layer 2, an n-AlGaN layer 3, and pillars 101 as well as air 9 among the pillars 101. The pillar 101 is formed of, in order from the +z-side to the -z-side, a part of the n-AlGaN layer 3, a multi-quantum well layer 4, an electron barrier layer 5, a p-AlGaN layer 6, a p-GaN contact layer 7, and a p-type electrode layer 8 (ITO). The photonic crystal periodic structure 100 has a photonic band gap for reflecting light with wavelength $\lambda$.

As described above, the UVC-LED includes, in order from the opposite side of the sapphire substrate 1 (substrate), the p-type electrode layer 8 formed from indium tin oxide (ITO), the p-GaN contact layer 7, the p-AlGaN layer 6 that is transparent to the wavelength $\lambda$, the electron barrier layer 5 that is transparent to the wavelength $\lambda$, the multi-quantum well layer 4 that is transparent to the wavelength $\lambda$, and the n-AlGaN layer 3 that is transparent to the wavelength $\lambda$. As illustrated in the drawing, the AlN layer 2 may be interposed between the n-AlGaN layer 3 and the sapphire substrate 1.

The photonic crystal periodic structure 100 includes a plurality of pillars 101 in a direction of the sapphire substrate 1 (thickness direction, that is, a direction orthogonal to a stacked surface of the sapphire substrate 1), which are formed in a range from an upper portion of the p-type electrode layer 8 (that is, an end portion in the -z-direction) to the inside of the n-AlGaN layer 3 along the thickness direction. The pillar 101 includes only a part of the n-AlGaN layer 3.

As illustrated in the xy-plan view of Fig. 1(b), the photonic crystal periodic structure 100 has a pillar structure in which each pillar 101 has a circular cross section with a radius R, having a larger refractive index than that of the air 9 in a space region, and the respective pillars are arranged in a regular triangular lattice at the period *a* in the xy-plane. The "space region" herein refers to the region of the photonic crystal periodic structure 100 in which the pillars 101 are not present, for example.

Fig. 1(b) illustrates only three pillars 101 for the purpose of simplifying the drawing. However, it is possible to provide more pillars 101.

In the above-described structure, a light with the wavelength λ emitted from the multi-quantum well layer 4 has TE light and TM light radiated in all directions to propagate through the medium while being elliptically polarized. A filling factor f of the photonic crystal is calculated by the following formula utilizing the radius R of the pillar constituting the photonic crystal periodic structure 100, and the period *a*:

$$f = 2\pi/3^{0.5} \times (R/a)^2 \qquad (\text{Formula 1})$$

The period *a* in the photonic crystal periodic structure 100 with the emission wavelength λ satisfies a Bragg condition with respect to light with the wavelength λ. That is, the following formula is satisfied:

$$m \times \lambda/n_{\text{eff}} = 2a \qquad (\text{Formula 2}),$$

where $n_{\text{eff}}$ denotes the effective refractive index of the photonic crystal periodic structure 100, *a* denotes the period of the photonic crystal periodic structure 100, and *m* denotes an order.

Provided that the refractive indices of two media that constitute the photonic crystal periodic structure 100 are referred to as $n_1$, $n_2$, the following formula is established:

$$n_{\text{eff}} = (n_2^2 + (n_1^2 - n_2^2) \times f)^{0.5} \qquad (\text{Formula 3}).$$

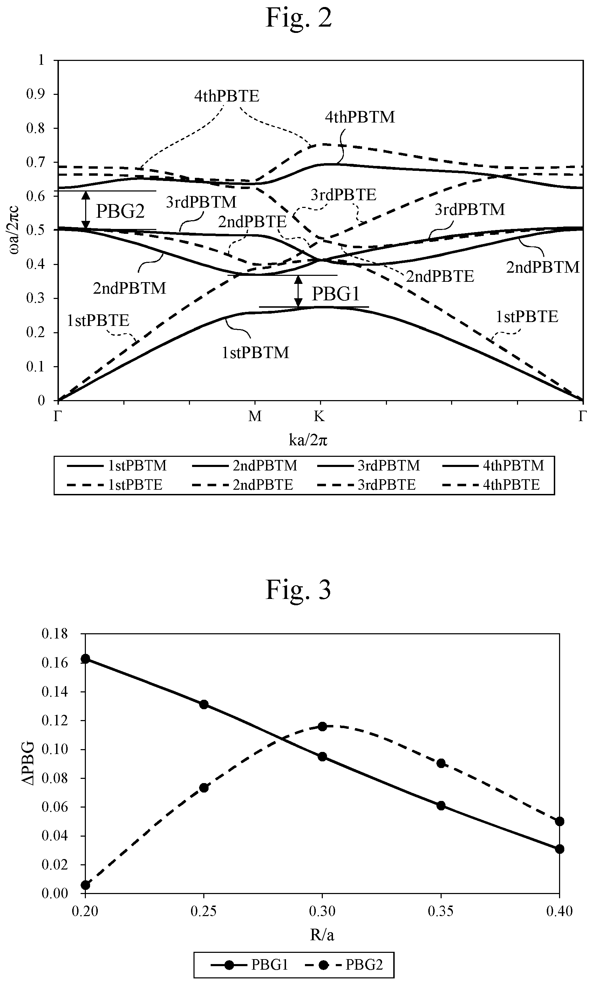

The photonic band structures of TE light and TM light are obtained using the plane wave expansion method to result in Fig. 2 by substituting λ = 220 nm, the refractive index $n_1$ = 2.814 of the light absorbing p-GaN contact layer 7, the air refractive index $n_2$ = 1, and R/a = 0.30 as the ratio of the radius R of the pillar 101 to the period *a* for those three formulae.

Regarding TM light, there is a photonic band gap PBG1 between the first photonic band and the second photonic band (second PBTM). There is a photonic band gap PBG2 between the third photonic band (third PBTM) and the fourth photonic band (fourth PBTM). As described above, the photonic crystal periodic structure 100 has the photonic band gap generated for a TM polarized component. Regarding TE light, there is no photonic band gap.

The photonic band structure is analyzed by the plane wave expansion method for each R/a = 0.20, 0.25, 0.30, 0.35, and 0.40 to obtain sizes of the PBG1 and PBG2. Fig. 3 illustrates the resultant graph having a horizontal axis as the R/a, and a vertical axis as the size of PBG (ΔPBG). It is preferable to set the R/a value in the range that satisfies 0.25 ≤ R/a ≤ 0.35 so as to secure large ΔPGB (for example, approximately 0.06 or larger) with respect to both the photonic band gaps PBG1 and PBG2.

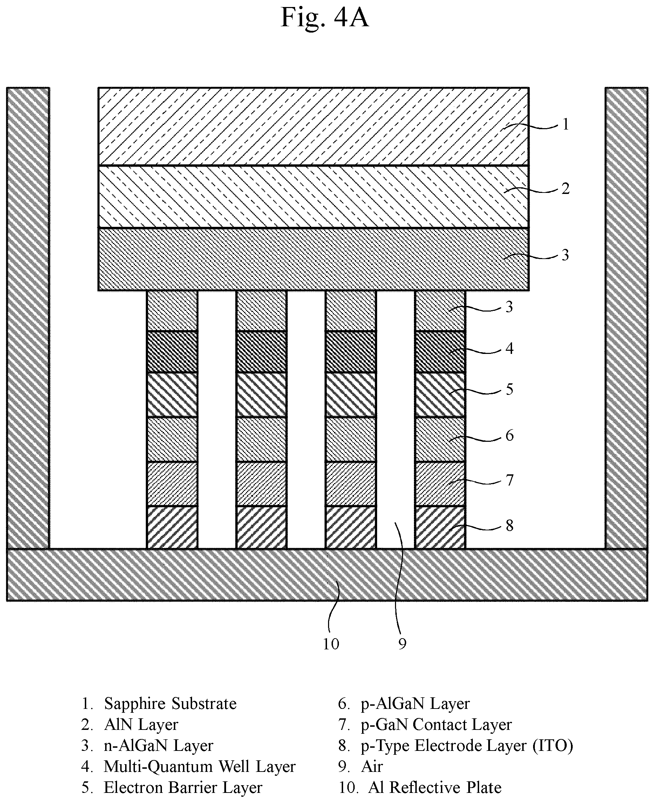

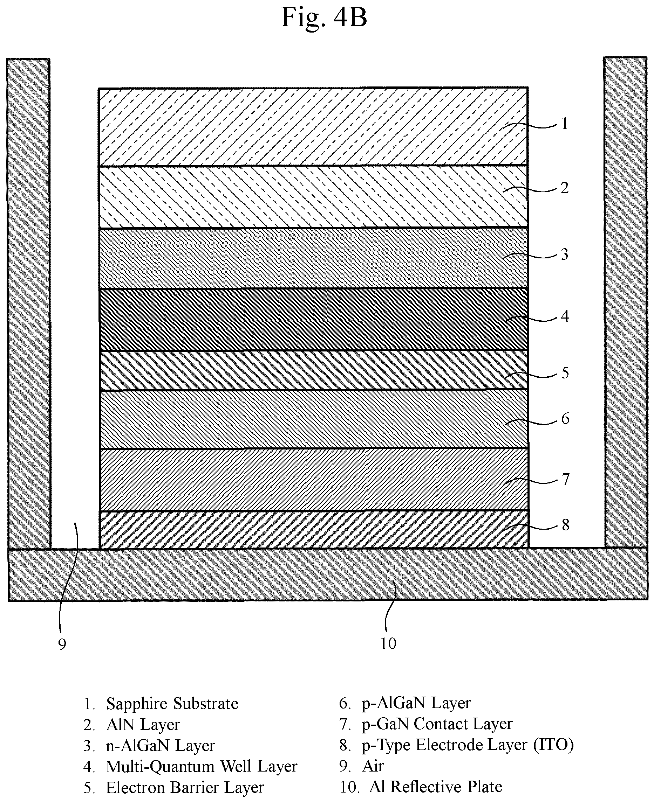

Computation models for the structure in the presence of the photonic crystal periodic structure (Fig. 4A) and the structure in the absence of the photonic crystal periodic structure (Fig. 4B) are generated for the purpose of studying the relationship of the LEE with the R/a, the ΔPBG, and the order *m.* In either structure, an Al reflective plate 10 is provided on an end surface of the p-type electrode layer 8 (on the end surface opposite to the p-GaN contact layer 7).

In the respective structures, output powers (W) are derived from a finite-difference time-domain (FDTD) method, and the LEE enhancement factor is computed from an output ratio of the structure having the photonic crystal to the structure having no photonic crystal. Table 1 represents the respective structures and optical parameters for the emission wavelengths 220 nm and 280 nm.

[Table 1]

| | Film Thickness (220 nm, 280 nm) | Al Composition (220 nm) | Refractive Index (220 nm) | Extinction Coefficient (220 nm) | Al Composition (280 nm) | Refractive Index (280 nm) | Extinction Coefficient (280 nm) |
|---|---|---|---|---|---|---|---|
| Sapphire Substrate | 1300 nm | - | 1.83 | - | - | 1.82 | - |
| AlN Layer | 400 nm | 100% | 2.615 | - | 100% | 2.316 | - |
| n-AlGaN Layer | 300 nm | 92% | 2.623 | - | 65% | 2.591 | - |
| Barrier Layer | 10 nm | 92% | 2.623 | - | 65% | 2.591 | - |
| Quantum Well Layer | 2 nm | 84% | 2.631 | - | 50% | 2.79 | - |
| Barrier Layer | 10 nm | 92% | 2.623 | - | 65% | 2.591 | - |
| Quantum Well Layer | 2 nm | 84% | 2.631 | - | 50% | 2.79 | - |
| Barrier Layer | 10 nm | 92% | 2.623 | - | 65% | 2.591 | - |
| Quantum Well Layer | 2 nm | 84% | 2.631 | - | 50% | 2.79 | - |
| Electron Barrier Layer | 2 nm | 100% | 2.615 | - | 100% | 2.316 | - |
| p-AlGaN Layer | 20 nm | 92% | 2.623 | - | 60% | 2.63 | - |
| p-GaN Contact Layer | 100 nm | - | 2.814 | 0.939 | - | 2.618 | 0.42 |
| p-Type Electrode Layer (ITO) | 50 nm | - | 2.336 | 0.305 | - | 2.341 | 0.133 |
| Al Reflective Layer | 200 nm | - | 0.147 | 2.57 | - | 0.241 | 3.357 |

Each term of "220 nm" and "280 nm" in the uppermost column denotes the emission wavelength (the same applies to Tables 2 to 4 as described below). Each value of the pillar diameter and the period is obtained by substituting the R/a = 0.25, 0.30, 0.35, each having the relatively larger ΔPBG as illustrated in Fig. 3, and the order $m$ = 3, 4, 5, 6, 7 for the three formulae. Each value of the pillar diameter and the period is similarly obtained for the emission wavelength of 280 nm. Table 2 represents the obtained data.

[Table 2]

| Order (m) | R/a | Diameter (220 nm) | Period (220 nm) | Diameter (280 nm) | Period (280 nm) |
|---|---|---|---|---|---|
| 3 | 0.25 | 103 nm | 206 nm | 138 nm | 275 nm |
| 3 | 0.3 | 110 nm | 183 nm | 148 nm | 246 nm |
| 3 | 0.35 | 114 nm | 163 nm | 155 nm | 221 nm |
| 4 | 0.25 | 137 nm | 275 nm | 184 nm | 367 nm |

(continued)

| Order (m) | R/a | Diameter (220 nm) | Period (220 nm) | Diameter (280 nm) | Period (280 nm) |
|---|---|---|---|---|---|
| 4 | 0.3 | 146 nm | 244 nm | 197 nm | 328 nm |
| 4 | 0.35 | 153 nm | 218 nm | 207 nm | 295 nm |
| 5 | 0.25 | 172 nm | 343 nm | 229 nm | 459 nm |
| 5 | 0.3 | 183 nm | 305 nm | 246 nm | 410 nm |
| 5 | 0.35 | 191 nm | 272 nm | 258 nm | 369 nm |
| 6 | 0.25 | 206 nm | 412 nm | 275 nm | 551 nm |
| 6 | 0.3 | 219 nm | 366 nm | 295 nm | 492 nm |
| 6 | 0.35 | 229 nm | 327 nm | 310 nm | 443 nm |
| 7 | 0.25 | 240 nm | 480 nm | 321 nm | 642 nm |
| 7 | 0.3 | 256 nm | 427 nm | 345 nm | 574 nm |
| 7 | 0.35 | 267 nm | 381 nm | 361 nm | 516 nm |

The pillar-type photonic crystal periodic structure in Table 2 is analyzed by the FDTD method to compute the LEE enhancement factor and the LEE (%). Table 3 represents the computed results.

[Table 3]

| Order (m) | R/a | LEE Enhancement Factor (220 nm) | LEE (%) (220 nm) | LEE Enhancement Factor (280 nm) | LEE (%) (280 nm) |
|---|---|---|---|---|---|
| 3 | 0.25 | 9.5 | 14.3% | 5.2 | 31.2% |
| 3 | 0.3 | 10.5 | 15.8% | 5.1 | 30.6% |
| 3 | 0.35 | 7.4 | 11.1% | 4.8 | 28.8% |
| 4 | 0.25 | 7.9 | 11.9% | 6.1 | 36.6% |
| 4 | 0.3 | 6.2 | 9.3% | 5.6 | 33.6% |
| 4 | 0.35 | 5.1 | 7.7% | 4.3 | 25.8% |
| 5 | 0.25 | 11.3 | 17.0% | 6.0 | 36.0% |
| 5 | 0.3 | 12.9 | 19.4% | 6.9 | 41.1% |
| 5 | 0.35 | 13.5 | 20.3% | 6.2 | 37.2% |
| 6 | 0.25 | 18.4 | 27.6% | 5.3 | 31.8% |
| 6 | 0.3 | 16.1 | 24.2% | 3.6 | 21.6% |
| 6 | 0.35 | 12.4 | 18.6% | 2.8 | 16.8% |
| 7 | 0.25 | 14.4 | 21.6% | 2.9 | 17.4% |
| 7 | 0.3 | 13.1 | 19.7% | 3.3 | 19.8% |
| 7 | 0.35 | 12.8 | 19.2% | 3.6 | 21.6% |

The method for computing the LEE (%) in Table 3 will be described. It is assumed that the LEE is 6% as the value computed for the emission wavelength of 280 nm in the absence of the photonic crystal periodic structure. As the output ratio of 220 nm/280 nm is 0.253, the LEE is 1.5% as the value computed for the emission wavelength of 220 nm in the absence of the photonic crystal periodic structure. The computation may be performed by multiplying each of those values by the enhancement factor derived from the respective structures.

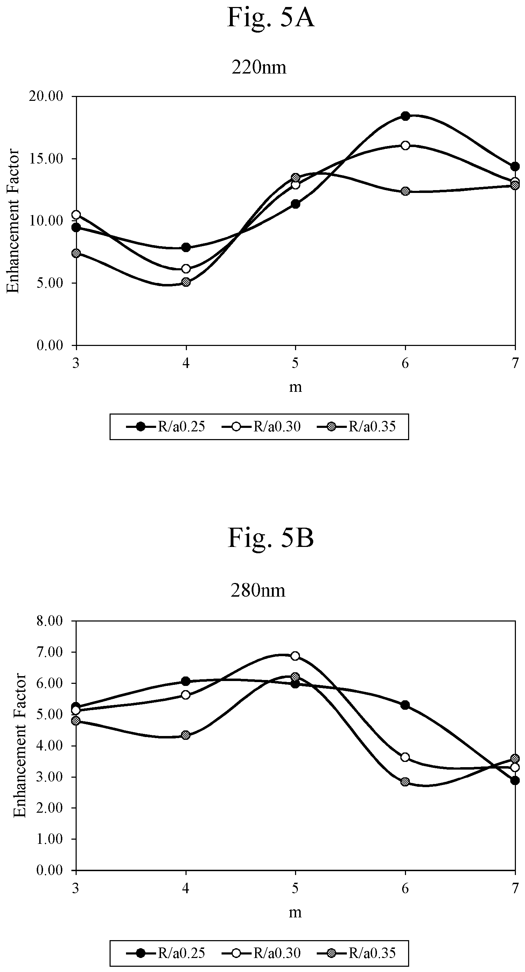

Fig. 5A and Fig. 5B illustrate graphs representing values of the R/a, each having a horizontal axis as the order *m,* and a vertical axis as the enhancement factor for the emission wavelengths of 220 nm and 280 nm. In this case, the same values for the analysis region, the spatial resolution, the number of steps, and the analysis time are used for both computation models for the emission wavelengths 220 nm and 280 nm. For the polarization degree: (TE light intensity - TM light intensity)/(TE light intensity + TM light intensity), the values were set at -0.13 at 220 nm and 0.40 at 280 nm.

As illustrated in Fig. 5A and Fig. 5B, it is preferable to set the order *m* to the value in the range that satisfies $3 \leq m \leq 7$ so as to secure the large enhancement factor. Results derived from Table 3, Fig. 5A, and Fig. 5B represent that the LEE becomes 1.5% for the emission wavelength of 220 nm in the absence of the photonic crystal periodic structure 100, which is reduced to be approximately 1/4 of the LEE of approximately 6%, by for the emission wavelength of 280 nm in the absence of the photonic crystal periodic structure. This is due to the increase in the extinction coefficient and decrease in the polarization degree of the p-GaN contact layer 7 to increase radiation of light from the lateral direction (direction parallel to the xy-plane), further increasing the light loss.

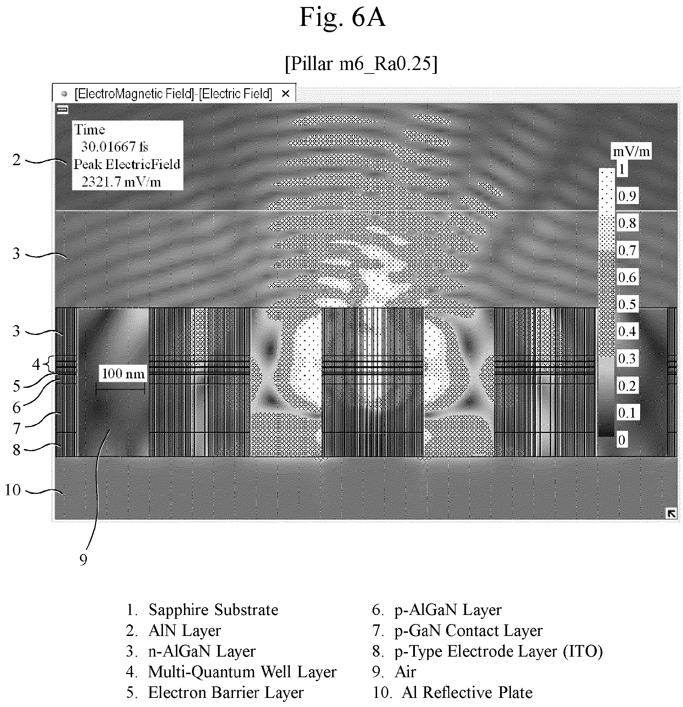

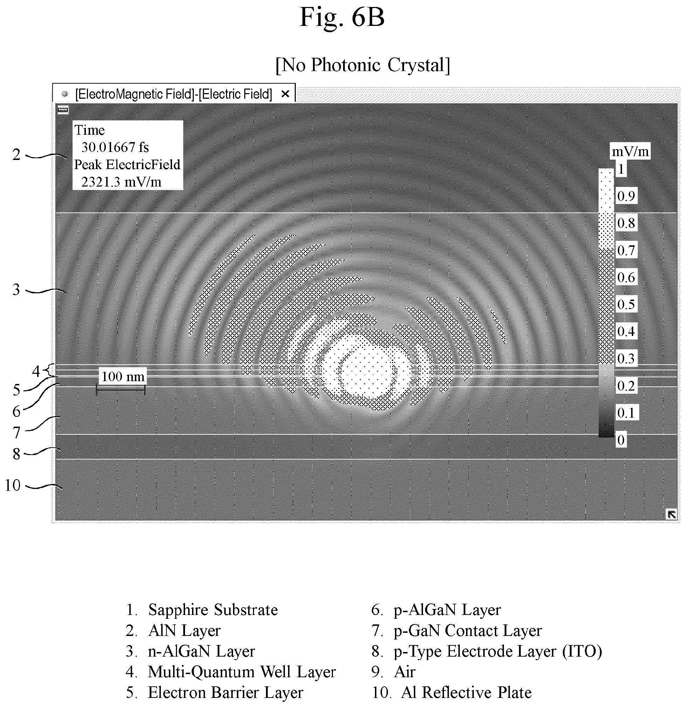

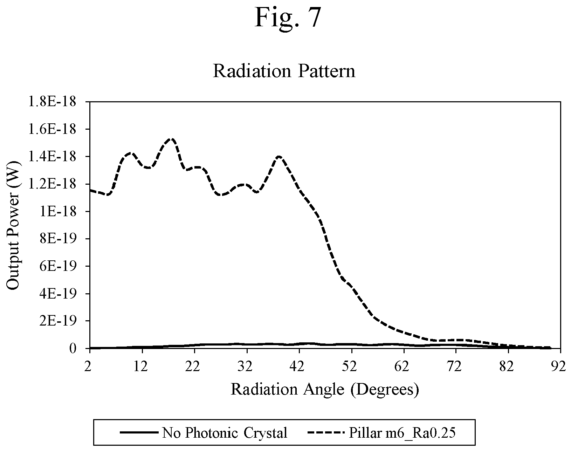

The thus formed pillar-type photonic crystal periodic structure 100 reflects light to be radiated from the direction of the sapphire substrate 1 to suppress the light loss. This significantly increases the LEE from 1.5% to the value ranging from 7.7% to 27.6%. This result can be clearly understood with reference to Fig. 6A and Fig. 6B indicating the comparison in the radio field intensity between the cases in the presence and absence of the photonic crystal periodic structure, and Fig. 7 as the graph having a horizontal axis as the radiation angle, and a vertical axis as the output power. Regarding the results derived from Fig. 6A and Fig. 7, the term "pillar m6_Ra0.25" denotes the condition of *m* = 6, R/a = 0.25. The reflection is considered to be influenced by each size ΔPBG of the photonic band gaps PBG1 and PBG2 as illustrated in Fig. 3 in the range of R/a from 0.25 to 0.35. This applies to the case for the emission wavelength of 280 nm, resulting in significant improvement in the LEE from 6% to the value ranging from 16.8% to 41.1%.

As described above, the UVC-LED according to the first embodiment of the present invention forms the pillar-type photonic crystal periodic structure 100 to allow significant improvement in the LEE.

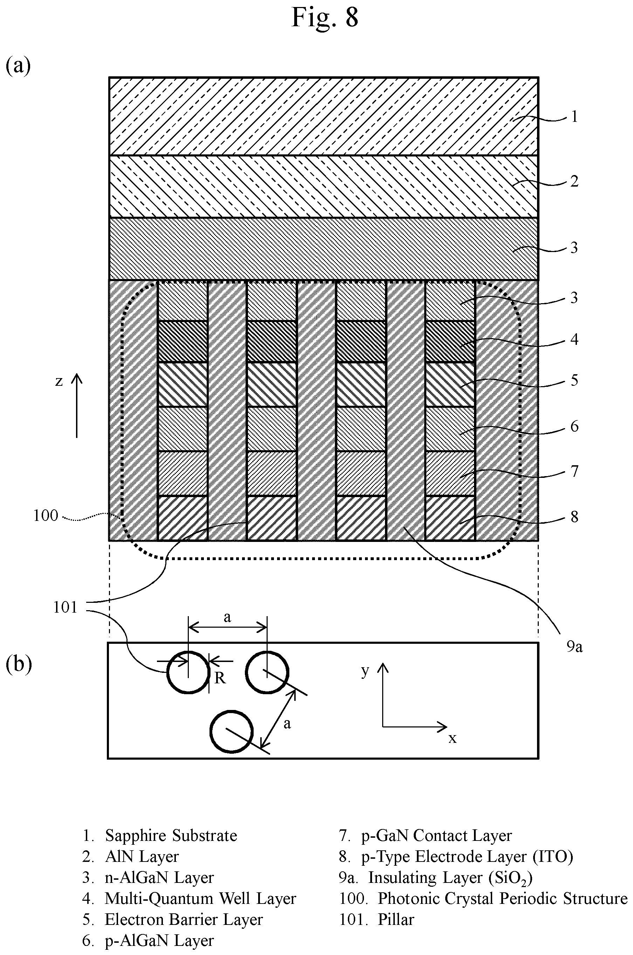

Fig. 8 illustrates a structure of a UVC-LED (a cross-sectional view and a plan view) with the emission wavelength λ of 220 nm as the UVC-LED according to a second embodiment of the present invention. Fig. 8(a) is a cross-sectional view, and Fig. 8(b) is a plan view seen from the lower direction of the drawing of Fig. 8(a).

Specifically, as illustrated in Fig. 8(a), a photonic crystal periodic structure 100 is formed of, in order from the +z-side to the -z-side, the sapphire substrate 1, the AlN layer 2, the n-AlGaN layer 3, and the pillars 101 as well as an insulating layer 9a ($SiO_2$) among the pillars 101. Like the first embodiment, the pillar 101 includes, in order from the +z-side to the -z-side, a part of the n-AlGaN layer 3, the multi-quantum well layer 4, the electron barrier layer 5, the p-AlGaN layer 6, the p-GaN contact layer 7, and the p-type electrode layer 8 (ITO).

The structure of this embodiment is substantially the same as that of the first embodiment except that the air 9 as illustrated in Fig. 1 is replaced with the insulating layer 9a. In the second embodiment, the insulating layer 9a formed of $SiO_2$ fills the space region in the photonic crystal periodic structure 100.

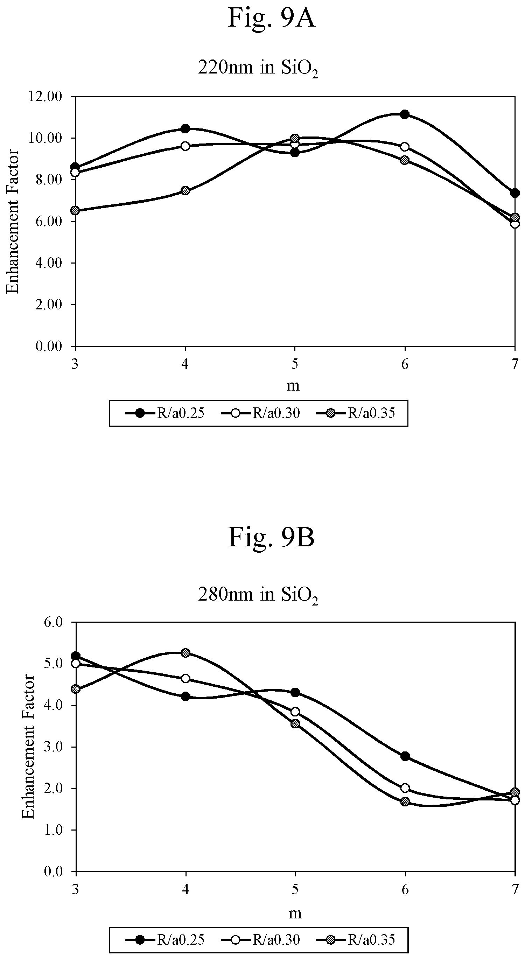

The pillar-type photonic crystal periodic structure represented in Table 2 is analyzed by the FDTD method. Table 4, Fig. 9A, Fig. 9B represent computed results of the LEE enhancement factors, and values of LEE (%). This embodiment uses the same computation method as the one used for the first embodiment. The refractive indices of the insulating layer 9a for the wavelengths of 220 nm and 280 nm result in 1.529 and 1.494, respectively.

[Table 4]

| Order (m) | R/a | LEE Enhancement Factor (220 nm) | LEE (%) (220 nm) | LEE Enhancement Factor (280 nm) | LEE (%) (280 nm) |
|---|---|---|---|---|---|
| 3 | 0.25 | 8.6 | 12.9% | 5.2 | 31.2% |
| 3 | 0.3 | 8.3 | 12.5% | 5.0 | 30.0% |
| 3 | 0.35 | 6.5 | 9.8% | 4.4 | 26.4% |
| 4 | 0.25 | 10.4 | 15.6% | 4.2 | 25.2% |
| 4 | 0.3 | 9.6 | 14.4% | 4.6 | 27.6% |
| 4 | 0.35 | 7.5 | 11.3% | 5.2 | 31.2% |
| 5 | 0.25 | 9.3 | 14.0% | 4.3 | 25.8% |
| 5 | 0.3 | 9.7 | 14.6% | 3.8 | 22.8% |
| 5 | 0.35 | 10.0 | 15.0% | 3.5 | 21.0% |
| 6 | 0.25 | 11.1 | 16.7% | 2.8 | 16.8% |
| 6 | 0.3 | 9.6 | 14.4% | 2.0 | 12.0% |
| 6 | 0.35 | 8.9 | 13.4% | 1.7 | 10.2% |
| 7 | 0.25 | 7.3 | 11.0% | 1.7 | 10.2% |
| 7 | 0.3 | 5.9 | 8.9% | 1.7 | 10.2% |

(continued)

| Order (m) | R/a | LEE Enhancement Factor (220 nm) | LEE (%) (220 nm) | LEE Enhancement Factor (280 nm) | LEE (%) (280 nm) |
|---|---|---|---|---|---|
| 7 | 0.35 | 6.2 | 9.3% | 1.9 | 11.4% |

The results derived from Table 4, Fig. 9A, Fig. 9B indicate the significant increase into the LEE ranging from 8.9% to 16.7% for the emission wavelength of 220 nm. As for the emission wavelength of 280 nm, the LEE has also been significantly improved into the range from 10.2% to 31.2%.

In the respective embodiments as described above, the configurations as illustrated in the accompanying drawings are not limited to those described above, but may be suitably modified within a range that exhibits advantageous effects of the present invention. In addition, the configurations may be suitably modified within a range of the object of the present invention. The respective components of the present invention may be arbitrarily selected within the scope of matters described in the claims. The selected components may also be included in the present invention.

Industrial Applicability

The present invention is applicable to the deep ultraviolet LED.

Reference Signs List

1        Sapphire substrate (substrate)
2        AlN layer
3        n-AlGaN layer
4        Multi-quantum well layer
5        Electron barrier layer
6        p-AlGaN layer
7        p-GaN contact layer
8        p-type electrode layer
9        Air
9a       Insulating layer
10       Al reflective plate
100      Photonic crystal periodic structure
101      Pillar
R        Radius of pillar
a        Period of photonic crystal periodic structure

All publications, patents, and patent applications as cited in this specification are incorporated by reference into this application.

**Claims**

1.   A deep ultraviolet LED with an emission wavelength $\lambda$, comprising, in order from an opposite side of a substrate:

a p-type electrode layer made of indium tin oxide (ITO);
a p-GaN contact layer;
a p-AlGaN layer transparent to the wavelength $\lambda$;
an electron barrier layer transparent to the wavelength $\lambda$;
a multi-quantum well layer transparent to the wavelength $\lambda$; and
a n-AlGaN layer transparent to the wavelength $\lambda$;
wherein the deep ultraviolet LED includes a photonic crystal periodic structure having a plurality of pillars within a range in a thickness direction from an upper portion of the p-type electrode layer to an inside of the n-AlGaN layer, in a direction of the substrate,
wherein the photonic crystal periodic structure has a photonic band gap that is open to a TM polarized component,

wherein a period **a** of the photonic crystal periodic structure satisfies a Bragg condition ($m \times \lambda/n_{eff} = 2a$, m: order, $n_{eff}$: effective refractive index of the photonic crystal periodic structure) with respect to a light with the wavelength $\lambda$,

the order **m** satisfies $3 \leq m \leq 7$, and

a radius R of the pillar satisfies $0.25 \leq R/a \leq 0.35$.

2. The deep ultraviolet LED according to claim 1,

wherein an insulating layer made of $SiO_2$ fills a space region of the photonic crystal periodic structure.

# Fig. 1

(a)

z ↑

100

101

(b)

a

R

y ↑

a

x

1. Sapphire Substrate
2. AlN Layer
3. n-AlGaN Layer
4. Multi-Quantum Well Layer
5. Electron Barrier Layer
6. p-AlGaN Layer

7. p-GaN Contact Layer
8. p-Type Electrode Layer (ITO)
9. Air
100. Photonic Crystal Periodic Structure
101. Pillar

## Fig. 2

## Fig. 3

# Fig. 4A

1. Sapphire Substrate
2. AlN Layer
3. n-AlGaN Layer
4. Multi-Quantum Well Layer
5. Electron Barrier Layer

6. p-AlGaN Layer
7. p-GaN Contact Layer
8. p-Type Electrode Layer (ITO)
9. Air
10. Al Reflective Plate

# Fig. 4B

1. Sapphire Substrate
2. AlN Layer
3. n-AlGaN Layer
4. Multi-Quantum Well Layer
5. Electron Barrier Layer

6. p-AlGaN Layer
7. p-GaN Contact Layer
8. p-Type Electrode Layer (ITO)
9. Air
10. Al Reflective Plate

# Fig. 5A

220nm

# Fig. 5B

280nm

# Fig. 6A

[Pillar m6_Ra0.25]

1. Sapphire Substrate
2. AlN Layer
3. n-AlGaN Layer
4. Multi-Quantum Well Layer
5. Electron Barrier Layer

6. p-AlGaN Layer
7. p-GaN Contact Layer
8. p-Type Electrode Layer (ITO)
9. Air
10. Al Reflective Plate

# Fig. 6B

## [No Photonic Crystal]

[ElectroMagnetic Field]-[Electric Field] ×

Time
30.01667 fs
Peak ElectricField
2321.3 mV/m

100 nm

mV/m
1
0.9
0.8
0.7
0.6
0.5
0.4
0.3
0.2
0.1
0

1. Sapphire Substrate
2. AlN Layer
3. n-AlGaN Layer
4. Multi-Quantum Well Layer
5. Electron Barrier Layer
6. p-AlGaN Layer
7. p-GaN Contact Layer
8. p-Type Electrode Layer (ITO)
9. Air
10. Al Reflective Plate

# Fig. 7

Radiation Pattern

# Fig. 8

(a)

z ↑

100

101

9a

(b)

1. Sapphire Substrate
2. AlN Layer
3. n-AlGaN Layer
4. Multi-Quantum Well Layer
5. Electron Barrier Layer
6. p-AlGaN Layer

7. p-GaN Contact Layer
8. p-Type Electrode Layer (ITO)
9a. Insulating Layer (SiO$_2$)
100. Photonic Crystal Periodic Structure
101. Pillar

# Fig. 9A

220nm in SiO$_2$

# Fig. 9B

280nm in SiO$_2$

## INTERNATIONAL SEARCH REPORT

| International application No. |
| --- |
| **PCT/JP2023/038231** |

| A. | CLASSIFICATION OF SUBJECT MATTER |
| --- | --- |

*H01L 33/10*(2010.01)i; *H01L 33/06*(2010.01)i; *H01L 33/32*(2010.01)i; *H01L 33/42*(2010.01)i
FI:   H01L33/10; H01L33/06; H01L33/32; H01L33/42

According to International Patent Classification (IPC) or to both national classification and IPC

| B. | FIELDS SEARCHED |
| --- | --- |

Minimum documentation searched (classification system followed by classification symbols)

H01L33/00-33/64; H01S5/00-5/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2011-54828 A (KYOTO UNIVERSITY) 17 March 2011 (2011-03-17)<br>entire text, all drawings | 1-2 |
| A | JP 2008-16836 A (SAMSUNG ELECTRO-MECHANICS CO., LTD.) 24 January 2008 (2008-01-24)<br>entire text, all drawings | 1-2 |
| A | WO 2015/008776 A1 (MARUBUN CORP.) 22 January 2015 (2015-01-22)<br>entire text, all drawings | 1-2 |
| A | JP 2016-42167 A (NIPPON TELEGRAPH AND TELEPHONE CORP.) 31 March 2016 (2016-03-31)<br>entire text, all drawings | 1-2 |

☐ Further documents are listed in the continuation of Box C.      ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **19 December 2023** | **09 January 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/038231**

| Patent document cited in search report | | | Publication date (day/month/year) | Patent family member(s) | | | Publication date (day/month/year) |
|---|---|---|---|---|---|---|---|
| JP | 2011-54828 | A | 17 March 2011 | (Family: none) | | | |
| JP | 2008-16836 | A | 24 January 2008 | US<br>entire text, all drawings<br>KR | 2008/0012028<br><br>10-2008-0003486 | A1<br><br>A | |
| WO | 2015/008776 | A1 | 22 January 2015 | US<br>entire text, all drawings<br>EP<br>CN<br>KR | 2016/0042102<br><br>2955762<br>105283968<br>10-2015-0099869 | A1<br><br>A1<br>A<br>A | |
| JP | 2016-42167 | A | 31 March 2016 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6156898 B

- JP 2022169829 A